(19) **Europäisches Patentamt / European Patent Office / Office européen des brevets**

(11) **EP 3 213 093 B1**

(12) **FASCICULE DE BREVET EUROPEEN**

(45) Date de publication et mention
de la délivrance du brevet:
**06.10.2021 Bulletin 2021/40**

(21) Numéro de dépôt: **15787937.0**

(22) Date de dépôt: **22.10.2015**

(51) Int Cl.:
**G01R 23/17** *(2006.01)*   **G01R 23/163** *(2006.01)*

(86) Numéro de dépôt international:
**PCT/EP2015/074544**

(87) Numéro de publication internationale:
**WO 2016/066532 (06.05.2016 Gazette 2016/18)**

(54) **SYSTÈME ET PROCÉDÉ D'ANALYSE D'UN SIGNAL HYPERFRÉQUENCE PAR IMAGERIE**

SYSTEM UND VERFAHREN ZUR ANALYSE EINES MIKROWELLENFREQUENZSIGNALS DURCH ABBILDUNG

SYSTEM AND METHOD FOR ANALYSIS OF A MICROWAVE FREQUENCY SIGNAL BY IMAGING

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.10.2014 FR 1402429**

(43) Date de publication de la demande:
**06.09.2017 Bulletin 2017/36**

(73) Titulaires:
• **THALES**
  **92400 Courbevoie (FR)**
• **Universität Leipzig**
  **04109 Leipzig (DE)**

(72) Inventeurs:
• **CHIPAUX, Mayeul**
  **9951 BM, PAYS-BAS (NL)**
• **TORAILLE, Loïc**
  **F-75014 Paris (FR)**
• **DEBUISSCHERT, Thierry**
  **F-91400 Orsay (FR)**
• **LARAT, Christian**
  **F-75006 Paris (FR)**

• **MORVAN, Loic**
  **F-91400 Orsay (FR)**
• **MEIJER, Jan**
  **44892 Bochum (DE)**
• **PEZZAGNA, Sébastien**
  **04275 Leipzig (DE)**

(74) Mandataire: **Marks & Clerk France**
**Immeuble "Visium"**
**22, avenue Aristide Briand**
**94117 Arcueil Cedex (FR)**

(56) Documents cités:
**WO-A1-2013/188732**

• **CHIPAUX MAYEUL ET AL: "Nitrogen vacancies (NV) centers in diamond for magnetic sensors and quantum sensing", PROCEEDINGS OF SPIE, SPIE - INTERNATIONAL SOCIETY FOR OPTICAL ENGINEERING, US, vol. 9370, 15 janvier 2015 (2015-01-15), pages 93701V-93701V, XP060044828, ISSN: 0277-786X, DOI: 10.1117/12.2084082 ISBN: 978-1-62841-730-2**

**Description**

DOMAINE DE L'INVENTION

La présente invention concerne le domaine de l'analyse d'un signal hyperfréquence , dont la fréquence est typiquement comprise entre quelques centaines de MHz et quelques dizaines de GHz. Plus particulièrement, l'invention s'applique à l'analyse spectrale du signal hyperfréquence.

ETAT DE LA TECHNIQUE

L'analyse spectrale de signaux hyperfréquence consiste à identifier les composantes fréquentielles d'un signal inconnu, et éventuellement leurs amplitudes respectives.

Les analyseurs de spectre commerciaux destinés à la caractérisation de signaux fonctionnent de la manière suivante : le signal d'entrée est démodulé en le mixant au signal d'un oscillateur local. Après un filtrage passe-bas, on obtient les composantes présentes dans une bande étroite autour de la fréquence de l'oscillateur local. Il est ensuite nécessaire d'effectuer un balayage de la fréquence de l'oscillateur local pour obtenir l'intégralité des informations sur le signal d'entrée sur une large fenêtre spectrale.

Cette solution a pour principal inconvénient d'être intrinsèquement lente à cause du balayage effectué. De plus elle nécessite une électronique complexe et est donc coûteuse et volumineuse.

Enfin, dans le cas de signaux évoluant dans le temps, l'état de l'art ne permet pas de contrôler toute la fenêtre spectrale simultanément (sauf à employer un analyseur pour chaque bande). La probabilité d'interception des signaux est au mieux de quelques %.

Pour des applications requérant une probabilité d'interception la plus proche possible de 100%, une solution alternative est de numériser directement sur la plus grande bande passante possible le signal d'entrée, puis d'effectuer des transformées de Fourier sur les échantillons obtenus. Cette solution présente deux limites :

- Les performances actuelles des convertisseurs analogique-numérique limitent la bande passante d'entrée à moins de 10 GHz, tout en présentant des dynamiques très insuffisantes au regard des besoins (principalement à cause de la gigue d'échantillonnage et des non-linéarités de conversion),
- Le débit de données à transmettre et à traiter est considérable (plusieurs centaines de Gb/s et plusieurs Tflops), aboutissant à un volume, une consommation et un prix rédhibitoires.

Si les performances de calcul et de gestion des grands débits de données progressent très rapidement (loi de Moore), il n'en est pas de même pour celles des convertisseurs analogique-numériques très large bande qui butent sur des limites fondamentales des composants électroniques.

Le document D1 Le WO2013/188732 décrit un système de caractérisation de radiations d'un circuit intégré (radiation électromagnétique dans le circuit) utilisant une couche de diamant avec des centres NV déposée sur le circuit et détectant une variation optique de la couche fonction d'une variation temporelle d'un champ magnétique appliqué.

Un but de la présente invention est de pallier les inconvénients précités en proposant un système et un procédé d'analyse spectrale permettant d'obtenir une « image » du spectre complet du signal d'entrée sur une large bande, sans balayage ni numérisation ou calcul.

DESCRIPTION DE L'INVENTION

Selon un premier aspect, la présente invention a pour objet un système d'analyse d'un signal hyperfréquence par imagerie comprenant :

- un matériau solide dont au moins une propriété optique est modifiable dans au moins une zone du matériau, lorsque la zone est simultanément en présence d'une excitation optique ou électrique et d'un signal hyperfréquence présentant au moins une fréquence coïncidant avec une fréquence de résonance du matériau,
  ledit matériau étant en outre adapté pour qu'une valeur de ladite fréquence de résonance varie en fonction de l'amplitude d'un champ magnétique,
- un générateur de champ magnétique configuré pour générer un champ magnétique présentant, à l'intérieur d'une partie de ladite zone, une variation spatiale d'amplitude selon une direction X, ledit matériau présentant alors une fréquence de résonance ($f_R(x)$) fonction d'une position selon ladite direction X, et
- un détecteur configuré pour recevoir une image de la zone selon la direction X, l'image présentant au moins une variation d'intensité issue de la modification de la propriété optique, dont une position dans l'image spectrale est fonction d'une valeur de fréquence correspondante du signal hyperfréquence à analyser illuminant la zone du matériau, lorsque la zone est simultanément en présence d'une excitation optique ou électrique et dudit champ magnétique.

Avantageusement, le matériau est de géométrie planaire, la direction X étant sensiblement contenue dans un plan du matériau.

Avantageusement le matériau est un cristal comprenant des centres colorés. Selon un mode de réalisation, le cristal est un substrat diamant comprenant des centres NV dans la maille cristalline du substrat, chaque centre NV étant constitué d'un atome d'azote substitué à un atome de carbone et couplé à une lacune, le couple atome d'azote/lacune constituant un centre coloré dans la maille cristalline.

Selon une variante la propriété optique est une absorption d'un faisceau optique sonde traversant ladite zone, la modification consistant en une variation de ladite absorption du faisceau optique sonde par la zone du matériau.

Selon une autre variante, la propriété optique est une luminescence, la modification consistant en une variation d'une intensité de luminescence de ladite zone, le système comprenant en outre un système optique configuré pour imager ladite zone sur ledit détecteur.

Avantageusement, les centres NV du substrat diamant présentent une direction privilégiée parmi les quatre directions possibles. Avantageusement, la direction privilégiée des centres NV est située dans un plan du matériau.

Avantageusement, la direction privilégiée des centres NV correspond à la direction X.

Avantageusement, le générateur de champ magnétique est configuré pour que la variation spatiale d'amplitude du champ magnétique soit monotone selon X dans ladite partie de la zone.

Avantageusement, le générateur de champ magnétique est configuré pour que la direction du champ magnétique soit sensiblement alignée avec une direction des centres NV.

Avantageusement, le générateur de champ magnétique est configuré pour que la direction du champ magnétique soit comprise dans un plan du matériau.

Avantageusement, le générateur de champ magnétique est configuré pour que la direction du champ magnétique soit parallèle à la direction X. Avantageusement, le générateur de champ magnétique est configuré pour que l'amplitude du champ magnétique soit sensiblement constante selon une direction Z perpendiculaire à un plan du matériau.

Selon un mode de réalisation, le système selon l'invention comprend en outre une antenne émettrice disposée à proximité du matériau et reliée à un câble coaxial dans lequel circule le signal hyperfréquence à analyser.

En variante, le système selon l'invention comprend en outre un dispositif de traitement configuré pour acquérir une pluralité d'images à des instants successifs et pour générer une image synthétique bidimensionnelle par juxtaposition des images spectrales acquises, de manière à rendre visuellement une évolution du spectre du signal hyperfréquence à analyser en fonction du temps.

Selon un autre aspect, l'invention concerne un procédé d'analyse d'un signal hyperfréquence par imagerie comprenant les étapes consistant à :

- exciter optiquement ou électriquement une zone d'un matériau solide dont au moins une propriété optique est modifiable dans ladite zone lorsque ladite zone est simultanément en présence de ladite excitation et d'un signal hyperfréquence présentant au moins une fréquence coïncidant avec une fréquence de résonance du matériau, le matériau étant en outre adapté pour qu'une valeur de la fréquence de résonance varie en fonction de l'amplitude d'un champ magnétique,

- générer un champ magnétique présentant, à l'intérieur d'une partie de ladite zone, une variation spatiale d'amplitude, ledit matériau présentant alors une fréquence de résonance fonction d'une position selon ladite direction X,

- recevoir sur un détecteur une image de ladite zone selon ladite direction X, ladite image présentant au moins une variation d'intensité dont une position dans ladite image est fonction d'une valeur de fréquence correspondante dudit signal hyperfréquence à analyser illuminant ledit matériau, lorsque ladite partie de la zone du matériau est simultanément excitée optiquement ou électriquement et soumise audit champ magnétique.

Selon un mode de réalisation, le procédé selon l'invention comprend en outre les étapes consistant à acquérir une pluralité d'images à des instants successifs et à générer une image synthétique bidimensionnelle par juxtaposition des images acquises, de manière à rendre visuellement une évolution du spectre du signal hyperfréquence à analyser en fonction du temps.

Avantageusement le procédé selon l'invention comprend en outre une étape de calibration consistant à générer une image synthétique à partir d'un signal hyperfréquence mono-fréquence dont la fréquence varie au cours du temps selon une loi connue, de manière à obtenir une correspondance entre position dans l'image et fréquence de résonance.

D'autres caractéristiques, buts et avantages de la présente invention apparaîtront à la lecture de la description détaillée qui va suivre et en regard des dessins annexés donnés à titre d'exemples non limitatifs et sur lesquels :

- La figure 1 décrit un système d'analyse spectrale selon l'invention,
- la figure 2 illustre les niveaux fondamentaux et excités du centre NV- dans une matrice cristalline,
- la figure 3 illustre le diagramme énergétique du centre NV
- la figure 4 illustre le déplacement des niveaux par effet Zeeman en présence d'un champ magnétique,
- la figure 5 illustre l'axe de quantification d'un centre NV correspondant à l'axe joignant l'atome d'azote à la lacune,
- la figure 6 illustre la détection optique des résonances magnétiques en fonction de la fréquence de résonance $f_R$, déplacées en présence d'un champ magnétique non nul par effet Zeeman,
- la figure 7 illustre une première option du système selon l'invention, selon laquelle la propriété optique est la luminescence,
- la figure 8 illustre une deuxième option du système selon l'invention, selon laquelle la propriété optique est l'absorption d'un faisceau sonde,

- la figure 9 illustre un exemple de variation de luminescence en fonction de la fréquence et de la position x en présence d'un champ magnétique B(x),
- la figure 10 illustre une relation bijective $f_R(x)$ obtenue dans une fenêtre sélectionnée,
- la figure 11 illustre le fonctionnement du système pour un cas dans lequel le signal hyperfréquence à analyser comprend 3 fréquences $f_{R1}$, $f_{R2}$, $f_{R3}$,
- la figure 12 illustre une configuration optique d'un système selon l'invention basé sur la luminescence,
- la figure 13 illustre une autre configuration optique d'un système selon l'invention basé sur la luminescence,
- la figure 14 illustre un exemple de génération d'un champ magnétique variable B(x),
- la figure 15 illustre un système selon l'invention comprenant une antenne émettrice disposée à proximité du matériau,
- la figure 16 schématise une antenne émettrice lithographiée à la surface du matériau,
- la figure 17 illustre un système selon l'invention compact,
- la figure 18 illustre un signal hyperfréquence HF variable au cours du temps à analyser,
- la figure 19 schématise une image synthétique obtenue avec un système selon l'invention comprenant un dispositif de traitement.

## DESCRIPTION DETAILLEE DE L'INVENTION

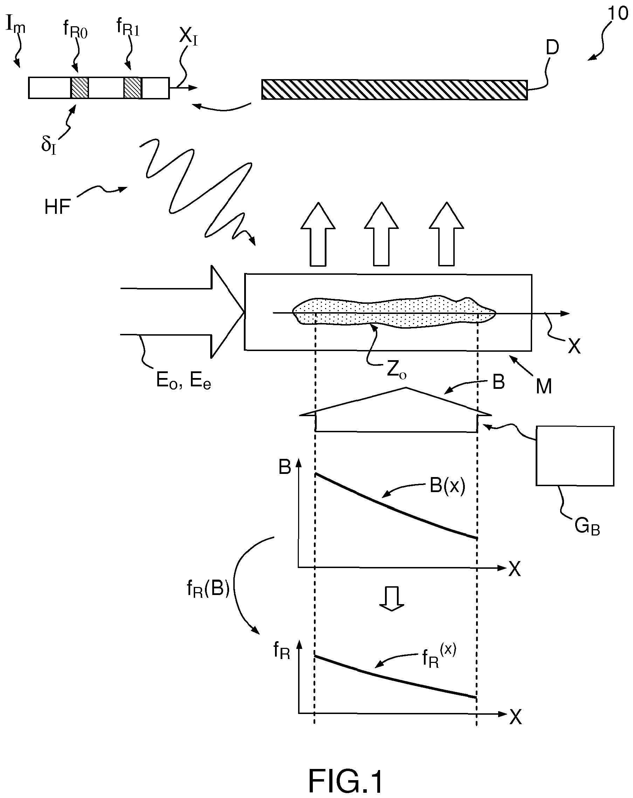

La figure 1 décrit un système 10 d'analyse d'un signal hyperfréquence HF par imagerie selon l'invention. Le système s'applique préférentiellement à des signaux hyperfréquence de fréquence comprise entre quelques centaines de MHz et quelques dizaines de GHz. Le système 10 comprend un matériau solide M dont au moins une propriété optique est modifiable dans au moins une zone Zo du matériau, lorsque cette zone est simultanément en présence d'une excitation optique Eo ou électrique Ee et d'un signal hyperfréquence HF présentant au moins une fréquence coïncidant avec une fréquence de résonance $f_R$ du matériau. Des exemples de propriété optiques sont donnés plus loin.

Le matériau solide M est en outre adapté pour qu'une valeur de la fréquence de résonance $f_R$ varie en fonction de l'amplitude d'un champ magnétique B. Un exemple d'effet physique permettant d'obtenir cet effet est détaillé plus loin.

Le système comprend en outre un générateur de champ magnétique $G_B$ configuré pour générer un champ magnétique B présentant, à l'intérieur d'une partie de la zone Zo, une variation spatiale d'amplitude B(x) selon une direction X.

Du fait de la dépendance de la fréquence de résonance en fonction de B, le matériau présente donc une fréquence de résonance $f_R(x)$ fonction d'une position x selon la direction X. Ainsi, en présence d'un signal hyperfréquence de fréquence coïncidant avec une fréquence de résonance $f_{R0}$ du matériau, une propriété optique du matériau est modifiée en $x_0$ selon X, $x_0$ étant la position correspondant à la fréquence $f_{R0}$. Cette variation de propriété optique se traduit par une variation locale d'énergie lumineuse en $x_0$. De cette manière, l'information fréquentielle est codée spatialement et optiquement dans le matériau M, et l'on obtient une relation directe entre la position x dans la zone Zo du matériau et la fréquence de résonance associée $f_R(x)$.

Enfin le système 10 comprend un détecteur D configuré pour recevoir une image Im de la zone Zo, et plus particulièrement de la partie de la zone Zo présentant une variation maîtrisée de champ magnétique B selon la direction X. Le codage de l'information spectrale est unidimensionnel, le détecteur D est unidimensionnel, ou bidimensionnel.

Ainsi l'image Im présente au moins une variation d'intensité $\delta I$ issue de la modification de la propriété optique, dont la position dans l'image Im est fonction de la valeur de fréquence correspondante du signal hyperfréquence HF à analyser illuminant la zone Zo du matériau, lorsque cette zone est simultanément en présence d'une excitation optique Eo ou électrique Ee et du champ magnétique B.

Le système 10 fournit ainsi directement une «projection» du spectre complet du signal HF à analyser sur une large bande, sans numérisation ni calcul. L'information spectrale est codée spatialement selon la direction X du matériau solide M. Un codage spatial correspondant se retrouve dans l'image Im selon une direction $X_I$.

Un avantage du système 10 selon l'invention est qu'il analyse toutes les fréquences du signal HF en même temps. Le système 10 est donc plus rapide qu'un système à balayage classique. De plus, du fait de sa simplicité, il est moins couteux et plus compact.

En variante, l'image Im une fois détectée par D subit des traitements pour améliorer la qualité et la lisibilité de l'information spectrale.

Préférentiellement, le matériau solide M présente une géométrie planaire, et la direction X est sensiblement contenue dans un plan du matériau. Cette géométrie permet une imagerie plus simple à mettre en œuvre et correspond à la géométrie d'un matériau de type cristal permettant l'obtention des effets physiques décrits ci-dessus. Préférentiellement, le matériau est un cristal comprenant des centres colorés. Nous allons dans la suite expliciter à titre d'exemple le fonctionnement du système 10 avec un matériau de ce type. Le cristal est par exemple un substrat de SiC, ou préférentiellement un substrat diamant comprenant des centres NV dans la maille cristalline du substrat, chaque centre NV étant constitué d'un atome d'azote substitué à un atome de carbone et couplé à une lacune, le couple atome d'azote/lacune constituant un centre coloré dans la maille cristalline.

Un centre NV est un défaut ponctuel de la maille cristalline, par exemple du diamant, formé par un atome d'azote (N) qui se substitue à un atome de carbone et auquel vient se coupler une lacune dans un site adjacent de la maille cristalline (V pour « vacancy »).

L'obtention de centres NV dans le diamant est bien maîtrisée. Des diamants de grande taille sont produits par un procédé CVD (pour Chemical Vapor Déposition en anglais) typiquement sous forme de parallélépipèdes de plusieurs mm de côté et de plusieurs centaines de $\mu$m d'épaisseur.

Les centres NV peuvent être créés par implantation ionique d'atomes d'azote. Ils peuvent également être créés en incorporant de l'azote de manière contrôlée au cours de la croissance du diamant par la méthode de « delta doping ». A la fin, le diamant est recuit (800°C) pour que les lacunes et les impuretés d'azote se recombinent pour former les centres NV. Les centres NV sont créés en volume ou en couches uniformes à proximité de la surface.

L'ensemble azote plus lacune formant le centre NV constitue ainsi un "atome artificiel", piégé au sein de la matrice de diamant et détectable optiquement à l'échelle individuelle par microscopie. Un centre NV possède une localisation bien précise qui ne varie pas dans le temps.

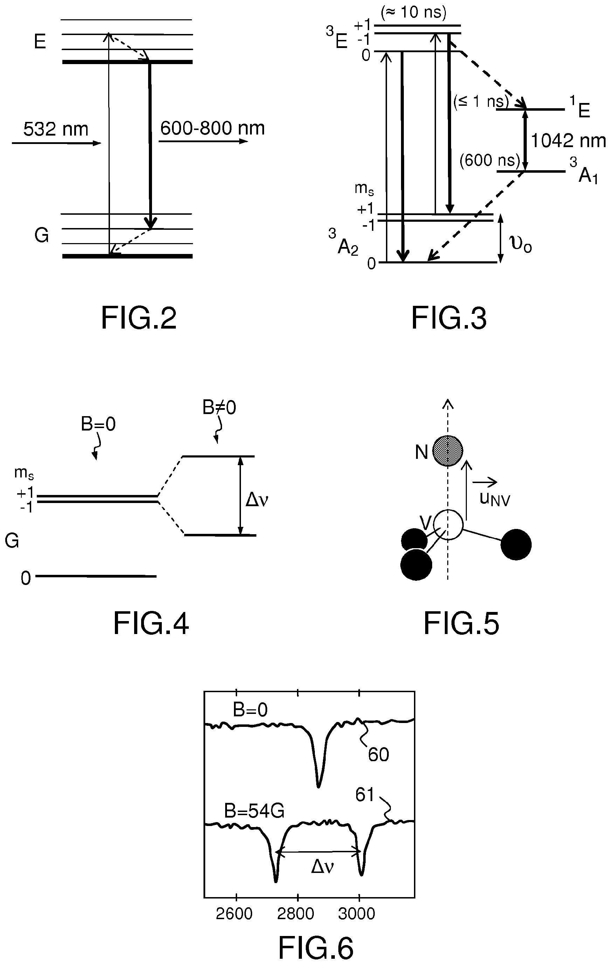

L'axe entre la lacune et l'atome d'azote constitue l'axe de quantification $u_{NV}$ du centre NV (illustré figure 5). De par la symétrie du cristal, cet axe peut prendre quatre orientations différentes.

Le centre NV possède des niveaux d'énergie fondamental G et excité E comme illustré sur la figure 2. L'excitation du centre NV s'effectue par pompage optique dans le vert (par ex. à 532 nm). Les centres NV émettent une luminescence rouge (centrée autour de 637 nm pour le centre NV chargé négativement).

Les niveaux en gras correspondent au système isolé de son environnement. La prise en compte de l'interaction entre le centre NV[-] et le réseau cristallin environnant se traduit par l'apparition de niveaux supplémentaires représentés en traits fins (élargissement par phonons). Le système, initialement dans l'état fondamental, est amené dans un état excité par absorption d'un photon de pompe. Une recombinaison non radiative l'amène vers le niveau excité de plus basse énergie (gras) Le retour vers l'état fondamental s'effectue par désexcitation radiative qui se traduit par l'émission d'une luminescence dans le rouge.

Il existe plusieurs configurations électroniques du centre NV. La configuration préférentielle pour la mise en oeuvre de l'invention est la configuration NV[-], chargée négativement. Par la suite nous utiliserons indifféremment la notation NV[-] et NV pour décrire le centre NV selon l'invention.

Le centre NV[-] est un système à deux électrons. Le niveau fondamental $^3A_2$ du centre NV[-] correspond à un niveau triplet S=1 du spin électronique, sa structure est illustré sur la figure 3.

Il existe une levée de dégénérescence entre le niveau $m_s$=0 d'une part et les niveaux $m_s$=-1 et $m_s$=+1 d'autre part, à la fois dans le niveau fondamental $^3A_2$ (v0 = 2.88 GHz) et dans le niveau excité $^3E$. Des transitions radiatives sont possibles entre niveaux de spin ($m_s$) identiques. Elles sont à l'origine de la luminescence des centres NV[-]. Un chemin de désexcitation non radiatif entre les niveaux excités $m_s$=+1 et $m_s$=-1 et le niveau fondamental $m_s$=0 est possible en passant par les niveaux $^1E$ et $^1A_1$. Le niveau $^1A_1$ a une durée de vie longue (niveau métastable). Cette transition permet le pompage optique du centre NV[-] avec une polarisation du centre principalement dans le niveau fondamental $m_s$=0. Cette transition explique également la plus faible luminescence d'un centre initialement dans l'état $m_s$=+1 ou $m_s$=-1 par rapport à un centre initialement dans l'état $m_s$=0.

Une propriété remarquable des centres NV[-] est donc de pouvoir polariser le spin dans son état $m_s$ = 0 par pompage optique, puis de pouvoir détecter optiquement la résonance de la transition $m_s$ = 0 -> $m_s$ = $\pm 1$.

Une première propriété optique est la sensibilité de la luminescence à un signal hyperfréquence et au champ magnétique, comme expliqué ci-dessous.

Lorsque le centre NV[-] est soumis à un rayonnement hyperfréquence de fréquence $v_0$ = 2.88 GHz résonant avec la transition $m_s$= 0 -> $m_s$ = $\pm 1$, on observe une baisse du niveau de luminescence, illustrée par la courbe 60 de la figure 6, ce qui permet de détecter la résonance (« Optically Detected Magnetic Resonance » - ODMR).

L'effet Zeeman consiste en un couplage entre un champ magnétique extérieur et le moment magnétique des électrons. Il se traduit par une levée de dégénérescence des niveaux $m_s$ = +1 et $m_s$ = -1, qui fait apparaitre deux résonances situées de part et d'autre de la fréquence centrale de 2.88 GHz séparées d'un intervalle $\Delta v$ tel qu'illustré figure 4 avec :

$$\Delta v = 2\frac{g\mu_B}{h}B_{NV}$$

g : Facteur de landé (très proche de 2)
h : Constante de Planck (6.62 e-34 $m^2$ kg / s)
$\mu_B$ : Magnéton de Bohr (-9.274 e-24 J/T)
$B_{NV}$ composante du champ magnétique extérieur B projetée sur l'axe de quantification $u_{NV}$ du centre NV[-].

Le facteur $\dfrac{g\mu_B}{h}$ vaut 28 MHz/mT

La position de ces deux fréquences varie proportionnellement à l'amplitude du champ magnétique. Comme décrit précédemment, on observe donc une variation du signal optique lorsque la fréquence du signal hyperfréquence HF coïncide avec ces deux résonances comme illustré par la courbe 61 de la figure 6.

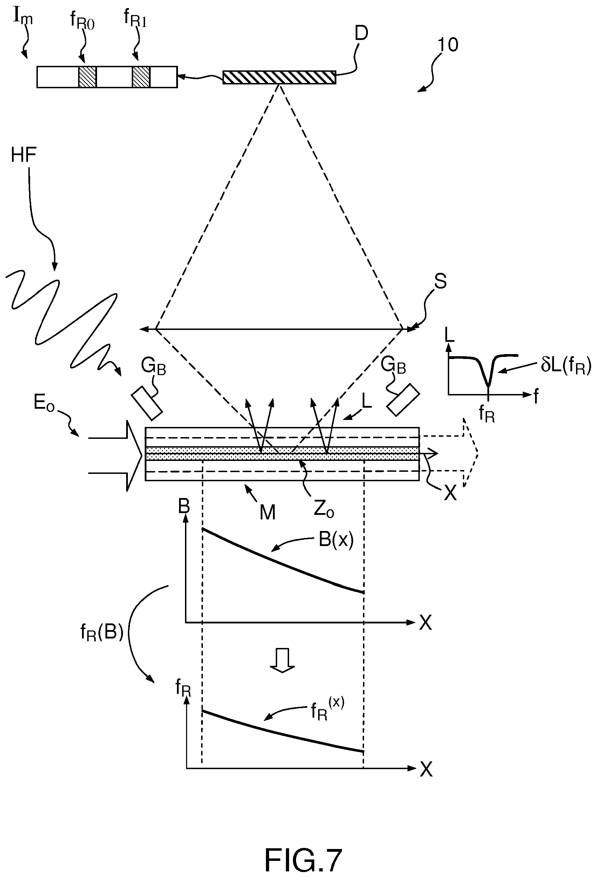

Ainsi selon une première option illustrée figure 7, la propriété optique du matériau utilisée est une luminescence L, qui se traduit par une émission de lumière lorsque le matériau est soumis à une excitation.

Pour un matériau solide M consistant en un substrat diamant comprenant des centres NV⁻, la luminescence est préférentiellement obtenue par une excitation optique Eo, typiquement une source lumineuse, tel un laser de pompe, émettant dans le visible, préférentiellement dans la bande [400 nm ; 650 nm].

En variante la luminescence est obtenue par une excitation électrique Ee, c'est à dire par génération d'un courant électrique circulant dans le matériau. Ceci peut être obtenu en créant une jonction P-N au voisinage des centres NV⁻.

Lorsque la fréquence du signal hyper HF coïncide avec une fréquence de résonance $f_R$ du matériau, l'intensité de luminescence est modifiée, typiquement on observe une diminution 5L de l'intensité.

Selon une variante le système comprend en outre un système optique S configuré pour imager la zone Zo sur le détecteur D.

Selon une autre variante le détecteur est disposé aussi près que possible de la zone émettrice Zo. Ainsi, on maintient la correspondance entre $x_0$, où se produit la modification de la propriété optique du matériau, et la position $x_i$ correspondante sur D.

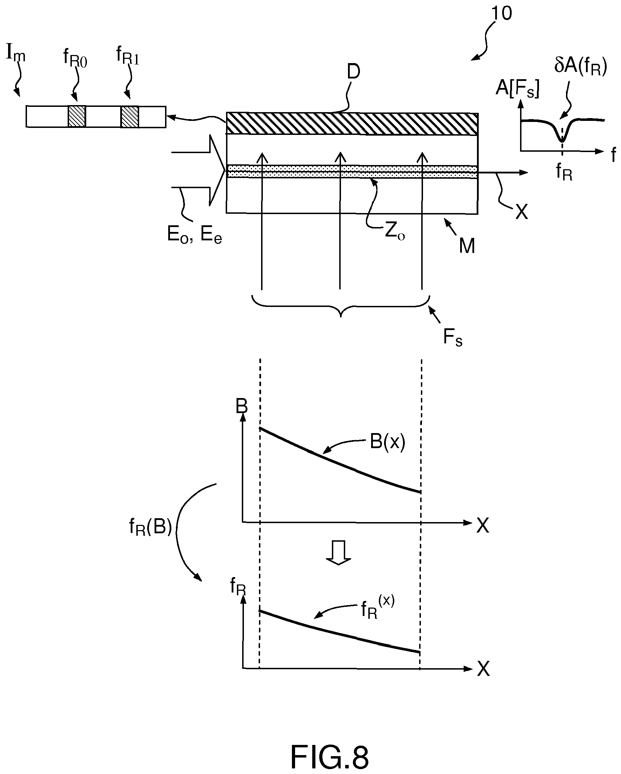

Selon une deuxième option, la propriété optique remarquable est la sensibilité de l'absorption d'un faisceau sonde Fs traversant la zone Zo du matériau M, à un signal hyperfréquence HF et au champ magnétique. L'application à un système 10 selon l'invention est illustrée figure 8, et expliqué ci-dessous pour l'exemple du diamant comprenant des centres NV⁻, donné à titre non limitatif.

Le diamant comprenant des centres NV, implantés en surface ou en volume, absorbe une partie de l'intensité d'un faisceau sonde de longueur d'onde IR, typiquement 1042 nm. Lorsque la fréquence du signal hyperfréquence coïncide avec une fréquence de résonance $f_R$ du diamant, 2.88 GHz en absence de champ magnétique extérieur, le système peut transiter du niveau $m_s=0$ vers les niveaux $m_s=+1/-1$ du triplet $^3A_2$, puis vers le niveau $m_s=+1/-1$ du triplet $^3E$. De là, il peut se recombiner de manière non radiative vers le niveau fondamental $m_s=0$ en passant par le niveau métastable. La durée de vie longue de ce niveau (600 ns) par rapport aux autres niveaux permet d'accumuler une population sur ce niveau.

En utilisant un faisceau sonde résonant avec la transition $^1A_1$ -> $^1E$ (1042 nm), il est alors possible d'obtenir un signal d'absorption proportionnel à la population du niveau $^1A_1$. Si la fréquence du signal hyperfréquence n'est pas résonante avec la transition à 2.88 GHz, le processus décrit précédemment n'est plus possible et la population du niveau M est plus faible que dans le cas précèdent. Par conséquent, l'absorption du faisceau sonde est également plus faible. On voit ainsi qu'une variation du signal d'absorption du faisceau sonde $\delta A(f_R)$ permet

de détecter si le signal hyperfréquence est résonant avec la transition à 2.88 GHz.

Dans le cas où un champ magnétique est appliqué, la dégénérescence des niveaux $^3A_2$ $m_s=-1$ et $m_s=+1$ est levée et deux diminutions de l'absorption sont observées en fonction de la fréquence, correspondant aux deux résonances. Le signal de sonde transmis est analogue à ce qui est décrit sur la figure 6.

Il est possible d'utiliser un faisceau sonde étendu de manière à couvrir toute la zone utile correspondant au gradient de champ magnétique pour ensuite pouvoir faire une image du faisceau sonde transmis et ainsi mesurer la fréquence du signal hyperfréquence en mesurant la position de l'augmentation d'absorption.

Pour une réception optimale des variations de l'intensité du faisceau sonde Fs, le détecteur D est préférentiellement disposé à proximité du matériau M, par exemple en contact direct avec une surface du matériau.

Nous allons à présent décrire des modes de réalisation préférentiels du système 10 basé sur la luminescence, ces modes de réalisation étant également applicables à un système 10 basé sur l'absorption d'un faisceau sonde.

Dans les diamants CVD standards, les centres NV sont orientés suivant 4 axes de quantification différents $u_{NV1}$ à $u_{NV4}$ (correspondant aux 4 directions principales de la structure cristallographique du diamant), et on a donc 4 couples de raies correspondant à la valeur de la projection du champ magnétique suivant chacun de ces axes.

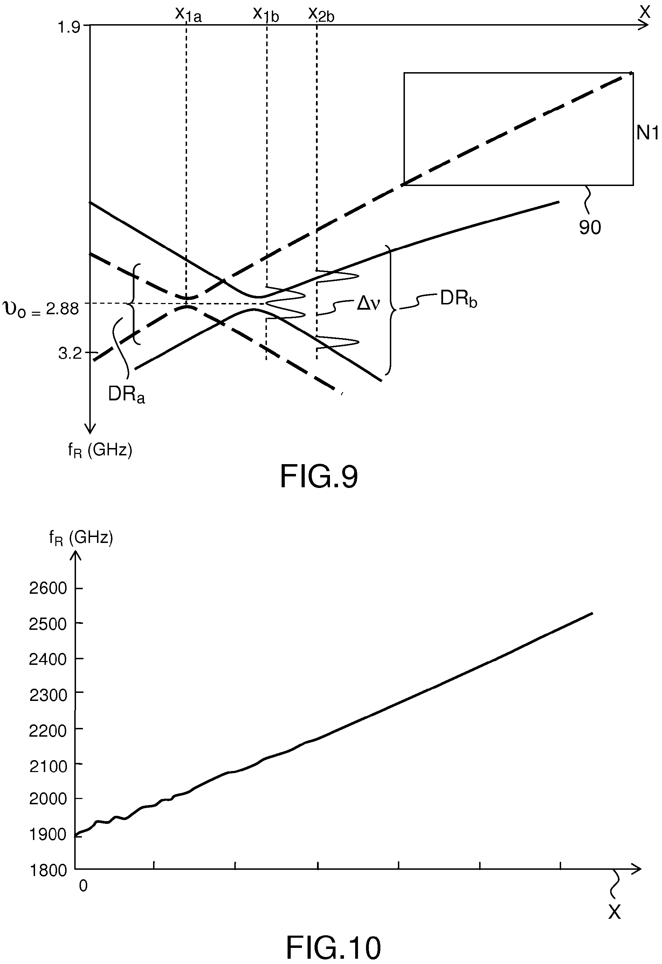

Lorsque le diamant est placé dans un gradient de champ magnétique B(x), la projection de B sur les 4 axes varie, et donc la position des fréquences de résonance varie. La figure 9 illustre un exemple de luminescence, en fonction de la position x selon le gradient (le résultat général dépend de la configuration du gradient et de la position du diamant dans celui-ci) et en fonction de la fréquence hyper $f_R$ en GHz. Sur cette figure la position x dans le gradient est donnée en abscisse, la fréquence est en ordonnée et les minimas de luminescence apparaissent en noir.

En balayant la fréquence par exemple entre 1.9 et 3.2 GHz, on observe un déplacement des fréquences de résonance en fonction de la position x. On voit toutefois que pour une position x, il peut exister plusieurs fréquences conduisant à la résonance. Il existe un couple d'hyperboles associé à chaque axe de quantification. La figure 9 montre deux couples associés à deux axes de quantification DRa (pointillés) et DRb (traits pleins).

Pour les deux axes de quantification DRa et DRb, les courbes donnant la résonance en fonction de la position x sont similaires mais décalées. Ainsi la fréquence v0 est obtenue pour deux positions différentes, x1a et x1b respectivement. Comme on peut le voir sur la figure 9, pour une position x donnée, plusieurs directions de centre NV peuvent donner lieu à des résonances pour des valeurs de fréquence différentes.

Il y a donc une ambiguïté entre la mesure de la résonance à une position x donnée et la détermination de la fréquence correspondante $f_R(x)$.

Une première solution pour lever cette ambiguïté est de se placer par exemple dans une zone indiquée par le cadre 90: Il existe alors une relation bijective entre la fréquence et la position puisqu'à une fréquence ne correspond qu'une seule résonance et donc qu'une seule valeur de x.

Une autre solution consiste à utiliser des cristaux d'orientation cristallographique de croissance [113] ou [111]. Dans ce cas, il est possible d'obtenir des cristaux où les centres NV⁻ ont une direction privilégiée DRp parmi les quatre possibles, ou bien même, sont tous orientés selon la même direction DRp. Ces diamants sont obtenus par croissance CVD dans une direction cristallographique particulière [111] ou [113]. On peut alors doper le matériau au cours de la croissance avec de l'azote pour fabriquer des centres NV, lesquels se forment alors préférentiellement dans la direction de la croissance.

On obtient ainsi une direction d'orientation unique pour les centres NV et il est alors possible avec ces cristaux d'avoir une correspondance non-ambiguë entre position et fréquence sur l'ensemble du spectre.

Pour simplifier l'interprétation des images, et limiter les effets de baisse de contraste, la direction privilégiée DRp est préférentiellement située dans un plan du matériau, ce qui est obtenu avec une direction cristallographique [111]. Préférentiellement cette direction est sensiblement parallèle à la direction X.

La figure 10 illustre la relation $f_R(x)$ bijective, pour des fréquences comprises entre 1.9 et 2.5 GHz, obtenue dans une fenêtre sélectionnée avec une variation B(x) de l'ordre de 10 mT sur environ 1 mm.

La courbe donnant la dépendance de B(x) avec x est similaire à celle donnant la dépendance de $f_R(x)$ avec x, puisque l'effet Zeeman est essentiellement linéaire pour ces valeurs.

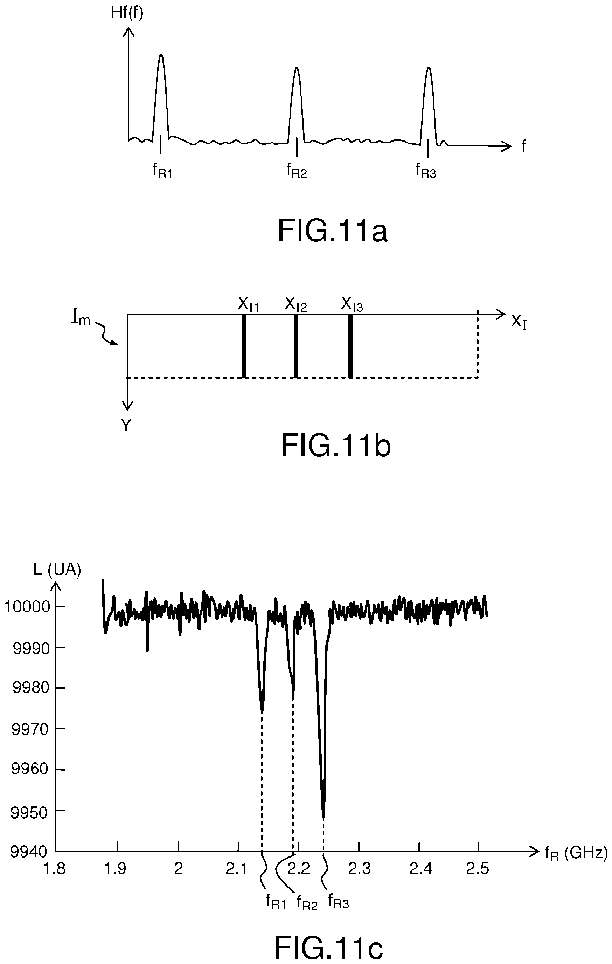

La figure 11 illustre le fonctionnement du système 10 pour un cas simple dans lequel le signal hyperfréquence à analyser comprend 3 fréquences $f_{R1}$, $f_{R2}$, $f_{R3}$.

La figure 11a décrit le spectre mesuré par un analyseur de spectre classique. Un système optique image la luminescence issue de la zone Zo soumise à un champ magnétique variable B(x).

La figure 11b illustre l'image Im obtenue, qui code spatialement les 3 fréquences $f_{R1}$, $f_{R2}$, $f_{R3}$ en trois zones obscures aux abscisses $X_{I1}$, $X_{I2}$, $X_{I3}$ d'un axe $X_I$ relié à l'axe X par le grandissement du système optique.

La figure 11c illustre la courbe d'intensité de luminescence L (unité arbitraire) en fonction de la fréquence, obtenue à partir de l'image Im en ayant transformé l'abscisse en fréquence correspondante, à l'aide d'une calibration. Des minima de luminescence apparaissent aux trois fréquences $f_{R1}$, $f_{R2}$ $f_{R3}$ du signal hyper HF illuminant le diamant.

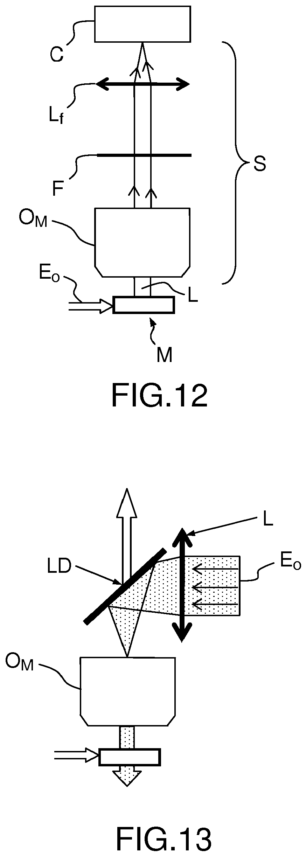

La figure 12 illustre un exemple de système 10 basé sur la luminescence. L'excitation optique Eo, un faisceau laser de pompe configuré pour émettre dans le visible, par exemple à 532 nm, illumine le matériau par la tranche et selon la direction X de variation du champ B. Le système optique S est constitué d'un objectif de microscope $O_M$, d'un filtre F et d'une lentille de focalisation Lf. Le détecteur D est compris dans une caméra C présentant un détecteur bidimensionnel classique, de technologie CCD ou CMOS par exemple. Une image 2D de la fluorescence est ainsi obtenue. Un avantage de cette configuration optique est que la direction du laser de pompe coïncide avec la direction X, ce qui permet d'utiliser efficacement une zone Zo importante, et avec une bonne uniformité de pompage.

Selon une autre variante illustrée figure 13, le signal optique d'excitation Eo est envoyé par le dessus via l'objectif de microscope $O_M$, à l'aide d'une lame dichroïque LD.

A titre illustratif, des expériences menées par les inventeurs ont été conduites selon une configuration illustrée figure 12 avec une puissance du laser de pompe de 300 mW, et un temps d'acquisition d'une image Im de 4 ms. La puissance du laser et le temps d'acquisition peuvent être diminués en utilisant un diamant comportant une densité de centres NV bien plus forte que celle du diamant utilisé pour cette expérience de démonstration.

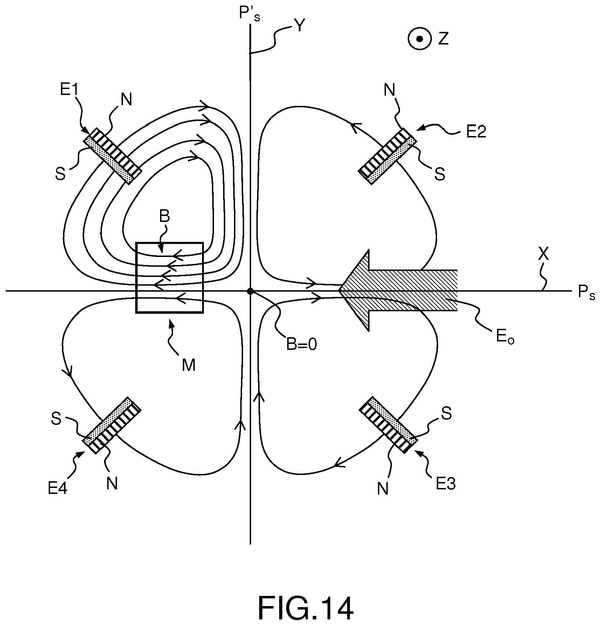

La figure 14 illustre un exemple de génération d'un champ magnétique variable B(x), utilisé classiquement pour le piégeage d'atomes froids.

Le générateur $G_B$ comprend quatre aimants E1, E2, E3, E4 disposés à 45° par rapport à deux plans de symétrie perpendiculaires Ps, Ps'. L'intersection entre les deux plans constitue une zone dans laquelle le champ magnétique est nul. Le matériau est disposé perpendiculairement aux plans de symétrie, la zone Zo étant située au voisinage d'une intersection avec un des plans de symétrie mais ne comprenant pas l'intersection entre les deux plans de symétrie. Dans cette configuration particulière d'aimants, l'amplitude du champ magnétique est une fonction croissante monotone de l'abscisse selon un plan de symétrie sur au moins une région. Ainsi, le plan de symétrie le long duquel le matériau est positionné correspond à la direction X. Une variation monotone du champ magnétique permet d'obtenir une large plage de fréquences de résonance.

Préférentiellement la direction du champ magnétique est sensiblement alignée (à +/- 20° près) avec une direction de quantification des centres NV. Cela permet de maximiser la projection du champ magnétique par rapport à la direction privilégiée des centres NV⁻, de préserver la linéarité de l'effet Zeeman sur une plus large gamme de fréquence et d'éviter les effets de baisse de contraste quand la composante transverse du champ (perpendiculaire à l'axe de quantification) devient trop importante.

De plus, l'interprétation des données est simplifiée et l'excursion en fréquence exploitable est maximisée.

En effet, l'effet de baisse de contraste tire son origine d'un défaut d'alignement entre l'axe du centre NV et la direction du champ magnétique. Lorsque le champ magnétique devient trop important, c'est lui qui impose l'axe de quantification, et non plus l'orientation du centre NV. Si le champ magnétique présente une composante transverse importante, les états propres du système ne sont plus les états de spin $m_s$=-1, $m_s$=0, $m_s$=+1, mais des combinaisons linéaires de ceux-ci. Par conséquent, la différence de luminescence en fonction de l'état de départ est moins marquée et à la limite disparait entièrement lorsque le champ est très intense. C'est l'effet baisse de contraste. Dans une configuration où le champ est aligné avec une direction de quantification des centres NV, on atteint une large plage de balayage spectral, typiquement de plusieurs dizaines de GHz, sans perdre les propriétés de luminescence des centres NV.

Outre l'avantage précédemment cité, l'alignement du champ magnétique avec une des directions de centre NV présente un avantage supplémentaire lorsque les quatre orientations possibles de centres sont présentes dans le diamant. Aligner le champ magnétique avec l'une des directions d'orientation des centres NV permet de sélectionner celle-ci lorsque le champ magnétique devient suffisamment intense. Les trois autres directions possibles, non alignées avec le champ magnétique, voient le contraste des résonances diminuer et le signal correspondant disparaitre. Il ne reste donc plus qu'un seul couple de résonances, ce qui a un effet similaire à ce qui serait obtenu avec un cristal où les centres NV auraient une direction unique privilégiées.

Lorsque la direction privilégiée DRp existe, avantageusement le champ magnétique est aligné avec cette direction.

Lorsque l'axe de quantification des centres NV⁻ n'est pas compris dans un plan du substrat, une option est d'incliner les aimants par rapport au diamant, En alignant bien le champ, une gamme d'analyse jusqu'à 30 GHz est obtenue dans le cas où les aimants utilisés produisent un champ de 1T au contact (la limite supérieure est déterminée par l'amplitude du champ magnétique). Une bande passante de 30 GHz divisée par une résolution de 5 MHz correspond à environ 6000 canaux d'analyse.

Préférentiellement, le générateur de champ magnétique $G_B$ est configuré pour que la direction du champ magnétique soit comprise dans un plan du matériau. Préférentiellement, le générateur de champ magnétique $G_B$ est configuré pour que la direction du champ magnétique soit parallèle à la direction X, ce qui est le cas de la configuration de la figure 14. Cela simplifie la géométrie globale du système et permet de maximiser la gamme de fréquence analysée.

Ainsi une configuration avantageuse est d'aligner selon la direction X (située dans un plan du matériau), la direction du champ magnétique, la direction privilégiée des centres NV et la direction du laser de pompe.

Avantageusement, le générateur de champ magnétique $G_B$ est configuré pour que l'amplitude du champ magnétique soit sensiblement constante selon une direction Z perpendiculaire à un plan XY du matériau. Cette caractéristique est obtenue avec la configuration de la figure 14 pour des aimants longs dans la direction Z, ce qui impose l'invariance du champ selon Z. Ceci permet à l'intégralité des centres NV⁻ situés selon un axe Z et ayant les même coordonnées (x,y) d'avoir la même fréquence de résonance. Il est donc possible de sommer toutes leurs contributions pour former le signal correspondant à un même pixel du champ de la caméra comprenant le détecteur.

Avantageusement, pour une largeur du faisceau du laser de pompe petite devant la distance aux aimants, on a une invariance du champ en Y. On a donc une invariance de la position de la résonance selon Y, ce qui permet de sommer toutes les contributions de chaque y pour un x donné, et ainsi d'améliorer la sensibilité.

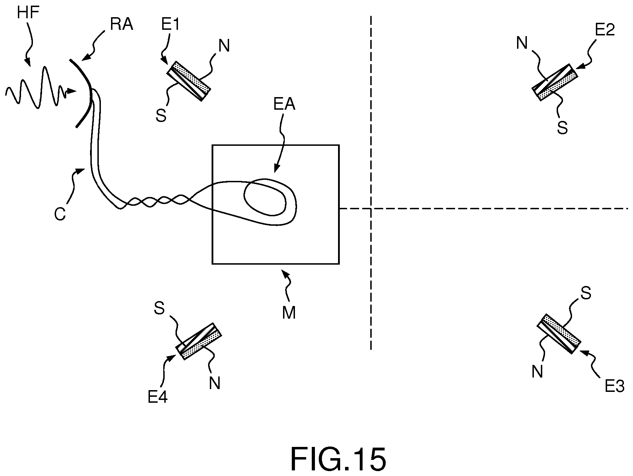

Pour envoyer le signal HF à analyser sur le système selon l'invention avec une meilleure efficacité, avantageusement le système 10 comprend une antenne émettrice EA disposée à proximité du matériau M et reliée à un câble coaxial C dans lequel circule le signal hyperfréquence HF à analyser, tel qu'illustré figure 15.

Avantageusement, le câble C est relié à une antenne réceptrice RA pour mieux capter le signal HF. L'antenne émettrice EA comprend par exemple une boucle permettant d'avoir un champ uniforme au niveau du cristal.

Le système 10 de l'expérience de démonstration précédent présente une sensibilité permettant de détecter des signaux d'une puissance au moins aussi basse que -10dBm pour un temps d'acquisition de 20s (puissance mesurée par le générateur à l'entrée du câble coaxial menant à l'antenne émettrice). Cette sensibilité est améliorée par l'utilisation d'une antenne plus adaptée permettant de concentrer plus efficacement le champ hyperfréquence sur la zone utile, telle une antenne de forme rectangulaire plutôt que circulaire.

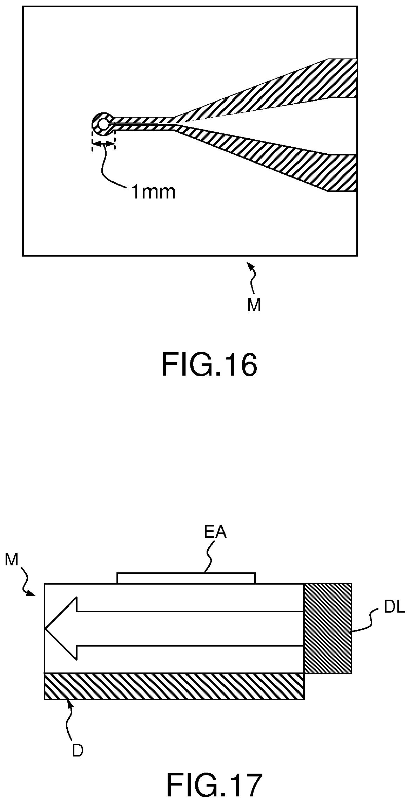

Pour réaliser un système compact, l'antenne émettrice est lithographiée à la surface du matériau, comme illustré figures 16 et 17. La figure 17 illustre un système 10 à compacité optimisée. Le laser de pompe est une diode laser DL directement au contact du diamant, un capteur CCD est directement collé sur le diamant et l'antenne EA est lithographiée sur sa surface du côté opposé au détecteur CCD.

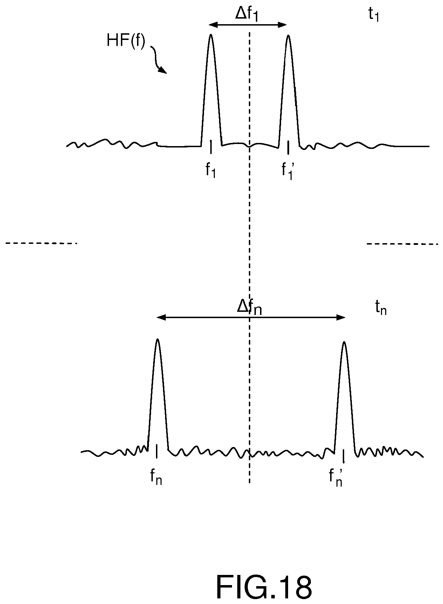

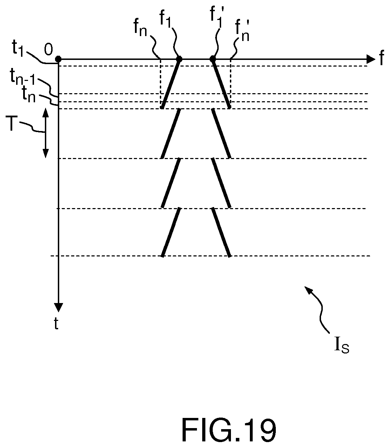

Selon une variante, et afin de donner une vision globale du spectre à analyser et de son évolution au cours du temps, le système 10 selon l'invention comprend en outre un dispositif de traitement configuré pour acquérir une pluralité d'images Im1, Im2, ...Imn respectivement à des instants successifs t1, t2..., tn et pour générer une image synthétique bidimensionnelle Is par juxtaposition des images spectrales acquises Im1, Im2, ...Imn, de manière à rendre visuellement une évolution du spectre du signal hyperfréquence HF à analyser en fonction du temps. Une image synthétique est illustrée figure 19, pour un signal HF à analyser illustré figure 18, bi-fréquence, les deux fréquences étant séparées d'un intervalle de fréquence Δf variable sur une période T entre une valeur $\Delta f_1$ et une valeur $\Delta f_n$.

Une telle image synthétique est communément dénommée spectrogramme, et donne à un spécialiste une vision instantanée de l'évolution du spectre au cours du temps.

Selon un autre aspect, l'invention concerne un procédé d'analyse d'un signal hyperfréquence HF par imagerie comprenant les étapes consistant à :

- exciter optiquement ou électriquement une zone Zo d'un matériau solide M dont au moins une propriété optique est modifiable dans ladite zone lorsque ladite zone est simultanément en présence de ladite excitation et d'un signal hyperfréquence présentant au moins une fréquence coïncidant avec une fréquence de résonance $f_R$ du matériau,

Le matériau étant en outre adapté pour qu'une valeur de la fréquence de résonance $f_R(B)$ varie en fonction de l'amplitude d'un champ magnétique,

- générer un champ magnétique B présentant, à l'intérieur d'une partie de ladite zone, une variation spatiale d'amplitude B(x), le matériau présentant alors une fréquence de résonance $f_R(x)$ fonction d'une position x selon la direction X,
- recevoir sur un détecteur D une image Im de la zone Zo selon la direction X, l'image Im présentant au moins une variation d'intensité δI dont une position dans l'image est fonction d'une valeur de fréquence correspondante du signal hyperfréquence HF à analyser illuminant le matériau M, lorsque la partie de la zone du matériau est simultanément excitée optiquement ou électriquement et soumise au champ magnétique B.

Avantageusement, le procédé comprend en outre les étapes consistant à acquérir une pluralité d'images Im1, Im2, Imn à des instants successifs t1, t2..., tn et à générer une image synthétique bidimensionnelle Is par juxtaposition des images acquises, de manière à rendre visuellement une évolution du spectre du signal hyperfréquence HF à analyser en fonction du temps.

Avantageusement, le procédé comprend en outre une étape de calibration consistant à générer une image synthétique à partir d'un signal hyperfréquence mono-fréquence dont la fréquence varie au cours du temps selon une loi connue, de manière à obtenir une correspondance entre position dans l'image et fréquence de résonance.

On peut par exemple utiliser un signal de calibration correspondant à un signal monochromatique connu dont on fait varier la fréquence. On détermine ensuite la fréquence de résonance pour chaque valeur de x, ce qui permet d'obtenir la correspondance fréquence/position.

**Revendications**

1. Système (10) d'analyse d'un signal hyperfréquence (HF) par imagerie comprenant :

   - un matériau solide (M) dont au moins une propriété optique est modifiable dans au moins une zone (Zo) dudit matériau, lorsque ladite zone est simultanément en présence d'une excitation optique (Eo) ou électrique (Ee) et d'un signal hyperfréquence présentant au moins une fréquence coïncidant avec une fréquence de résonance ($f_R$) du matériau, ledit matériau étant en outre adapté pour qu'une valeur de ladite fréquence de résonance ($f_R(B)$) varie en fonction de l'amplitude d'un champ magnétique,
   - un générateur de champ magnétique ($G_B$) configuré pour générer un champ magnétique (B) présentant, à l'intérieur d'une partie de ladite zone, une variation spatiale d'amplitude (B(x)) selon une direction X, ledit matériau présentant alors une fréquence de résonance ($f_R(x)$) fonction d'une position (x) selon ladite direction X, et
   - un détecteur (D) configuré pour recevoir une image (Im) de ladite zone (Zo) selon ladite direction X, ladite image présentant au moins une variation d'intensité (δI) issue de la modification de la propriété optique, dont une position dans l'image spectrale est fonction d'une valeur de fréquence correspondante dudit signal hyperfréquence (HF) à analyser illuminant ladite zone du matériau, lorsque ladite zone est simultanément en présence d'une excitation optique (Eo) ou électrique (Ee) et dudit champ magnétique (B).

2. Système selon la revendication 1 dans lequel le matériau est de géométrie planaire, la direction X étant sensiblement contenue dans un plan du matériau.

3. Système selon l'une des revendications 1 ou 2 dans lequel le matériau est un cristal comprenant des centres colorés.

4. Système selon la revendication 3 dans lequel le cristal est un substrat diamant comprenant des centres NV dans la maille cristalline dudit substrat, chaque centre NV étant constitué d'un atome d'azote substitué à un atome de carbone et couplé à une lacune, le couple atome d'azote/lacune constituant un centre coloré dans ladite maille cristalline.

5. Système selon l'une des revendications précédentes dans lequel ladite propriété optique est une absorption d'un faisceau optique sonde (Fs) traversant ladite zone (Zo), ladite modification consistant en une variation de ladite absorption (δA[Fs]) dudit faisceau optique sonde (Fs) par ladite zone du matériau.

**6.** Système selon l'une des revendications précédentes dans lequel ladite propriété optique est une luminescence, ladite modification consistant en une variation d'une intensité de luminescence ($\delta L$) de ladite zone, ledit système comprenant en outre un système optique (S) configuré pour imager ladite zone (Zo) sur ledit détecteur (D).

**7.** Système selon l'une des revendications 3 à 6 dans lequel lesdits centres NV du substrat diamant présentent une direction privilégiée (DRp) parmi les quatre directions possibles.

**8.** Système selon la revendication 7 dans lequel la direction privilégiée (DRp) des centres NV est située dans un plan du matériau.

**9.** Système selon la revendication 8 dans lequel la direction privilégiée (DRp) des centres NV correspond à la direction X.

**10.** Système selon l'une des revendications précédentes dans lequel le générateur de champ magnétique ($G_B$) est configuré pour que la variation spatiale d'amplitude du champ magnétique soit monotone selon X dans ladite partie de la zone (Zo).

**11.** Système selon l'une des revendications 3 à 10 dans lequel le générateur de champ magnétique ($G_B$) est configuré pour que la direction du champ magnétique soit sensiblement alignée avec une direction des centres NV.

**12.** Système selon l'une des revendications 2 à 11 dans lequel le générateur de champ magnétique ($G_B$) est configuré pour que la direction du champ magnétique soit comprise dans un plan du matériau.

**13.** Système selon l'une des revendications 2 à 12 dans lequel le générateur de champ magnétique ($G_B$) est configuré pour que la direction du champ magnétique soit parallèle à la direction X.

**14.** Système selon l'une des revendications 2 à 13 dans lequel le générateur de champ magnétique est configuré pour que l'amplitude du champ magnétique soit sensiblement constante selon une direction Z perpendiculaire à un plan du matériau.

**15.** Système selon l'une des revendications précédentes comprenant en outre une antenne émettrice (EA) disposée à proximité dudit matériau (M) et reliée à un câble coaxial (C) dans lequel circule le signal hyperfréquence (HF) à analyser.

**16.** Système selon l'une des revendications précédentes comprenant un dispositif de traitement configuré pour acquérir une pluralité d'images à des instants successifs (t1, t2..., tn) et pour générer une image synthétique bidimensionnelle (Is) par juxtaposition des images spectrales acquises, de manière à rendre visuellement une évolution du spectre du signal hyperfréquence (HF) à analyser en fonction du temps.

**17.** Procédé d'analyse d'un signal hyperfréquence (HF) par imagerie comprenant les étapes consistant à :

- exciter optiquement ou électriquement une zone (Zo) d'un matériau solide (M) dont au moins une propriété optique est modifiable dans ladite zone lorsque ladite zone est simultanément en présence de ladite excitation et d'un signal hyperfréquence présentant au moins une fréquence coïncidant avec une fréquence de résonance ($f_R$) du matériau,
ledit matériau étant en outre adapté pour qu'une valeur de la fréquence de résonance ($f_R(B)$) varie en fonction de l'amplitude d'un champ magnétique,
- générer un champ magnétique (B) présentant, à l'intérieur d'une partie de ladite zone, une variation spatiale d'amplitude (B(x)), ledit matériau présentant alors une fréquence de résonance ($f_R(x)$) fonction d'une position (x) selon ladite direction X,
- recevoir sur un détecteur (D) une image (Im) de ladite zone (Zo) selon ladite direction X, ladite image présentant au moins une variation d'intensité ($\delta I$) dont une position dans ladite image est fonction d'une valeur de fréquence correspondante dudit signal hyperfréquence (HF) à analyser illuminant ledit matériau, lorsque ladite partie de la zone du matériau est simultanément excitée optiquement ou électriquement et soumise audit champ magnétique (B).

**18.** Procédé selon la revendication 17 comprenant en outre les étapes consistant à acquérir une pluralité d'images à des instants successifs (t1, t2..., tn) et à générer une image synthétique bidimensionnelle (Is) par juxtaposition des images acquises, de manière à rendre visuellement une évolution du spectre du signal hyperfréquence (HF) à analyser en fonction du temps.

**19.** Procédé selon l'une des revendications 17 ou 18 comprenant en outre une étape de calibration consistant à générer une image synthétique à partir d'un signal hyperfréquence mono-fréquence dont la fréquence varie au cours du temps selon une loi connue, de manière à obtenir une correspondance entre position dans l'image et fréquence de résonance.

**Patentansprüche**

1. System (10) zum Analysieren eines Mikrowellenfrequenzsignals (HF) durch Bildgebung, das Folgendes umfasst:

   - ein festes Material (M), von dem mindestens eine optische Eigenschaft in mindestens einer Zone (Zo) des Materials modifizierbar ist, wenn in der Zone gleichzeitig eine optische (Eo) oder elektrische (Ee) Anregung und ein Mikrowellenfrequenzsignal mit mindestens einer Frequenz vorliegen, die mit einer Resonanzfrequenz ($f_R$) des Materials zusammenfällt, wobei das Material ferner so ausgelegt ist, dass ein Wert der Resonanzfrequenz ($f_R(B)$) in Abhängigkeit von der Amplitude eines Magnetfeldes variiert,
   - einen Magnetfeldgenerator ($G_B$), konfiguriert zum Erzeugen eines Magnetfelds (B), das innerhalb eines Teils der Zone eine räumliche Amplitudenvariation (B(x)) in einer Richtung X aufweist, wobei das Material dann eine Resonanzfrequenz ($f_R(x)$) in Abhängigkeit von einer Position (x) in der Richtung X aufweist, und
   - einen Detektor (D), konfiguriert zum Empfangen eines Bildes (Im) der Zone (Zo) in der Richtung X, wobei das Bild mindestens eine Intensitätsvariation ($\delta I$) aufweist, die sich aus der Modifikation der optischen Eigenschaft ergibt, von der eine Position im Spektralbild von einem entsprechenden Frequenzwert des zu analysierenden Mikrowellenfrequenzsignals (HF) abhängig ist, das die Zone des Materials beleuchtet, wenn in der Zone gleichzeitig eine optische (Eo) oder elektrische (Ee) Anregung und das Magnetfeld (B) vorliegen.

2. System nach Anspruch 1, wobei das Material eine planare Geometrie aufweist, wobei die Richtung X im Wesentlichen in einer Ebene des Materials liegt.

3. System nach Anspruch 1 oder 2, wobei das Material ein Kristall ist, welcher farbige Zentren umfasst.

4. System nach Anspruch 3, wobei der Kristall ein Diamantsubstrat ist, das NV-Zentren im Kristallgitter des Substrats umfasst, wobei jedes NV-Zentrum aus einem Stickstoffatom besteht, das ein Kohlenstoffatom substituiert und mit einer Lücke gekoppelt ist, wobei das Stickstoffatom/Lücke-Paar ein farbiges Zentrum in dem Kristallgitter bildet.

5. System nach einem der vorherigen Ansprüche, wobei die optische Eigenschaft eine Absorption eines optischen Sondenstrahls (Fs) ist, der die Zone (Zo) durchquert, wobei die Modifikation in einer Variation der Absorption ($\delta A[Fs]$) des optischen Sondenstrahls (Fs) durch die Zone des Materials besteht.

6. System nach einem der vorherigen Ansprüche, wobei die optische Eigenschaft Lumineszenz ist, wobei die Modifikation in einer Variation einer Lumineszenzintensität ($\delta L$) der Zone besteht, wobei das System ferner ein optisches System (S) umfasst, das zum Abbilden der Zone (Zo) auf dem Detektor (D) konfiguriert ist.

7. System nach einem der Ansprüche 3 bis 6, wobei die NV-Zentren des Diamantsubstrats eine bevorzugte Richtung (DRp) unter den vier möglichen Richtungen aufweisen.

8. System nach Anspruch 7, wobei die bevorzugte Richtung (DRp) der NV-Zentren in einer Ebene des Materials liegt.

9. System nach Anspruch 8, wobei die bevorzugte Richtung (DRp) der NV-Zentren der Richtung X entspricht.

10. System nach einem der vorherigen Ansprüche, wobei der Magnetfeldgenerator ($G_B$) so konfiguriert ist, dass die räumliche Variation der Magnetfeldamplitude entlang X in dem Teil der Zone (Zo) monoton ist.

11. System nach einem der Ansprüche 3 bis 10, wobei der Magnetfeldgenerator ($G_B$) so konfiguriert ist, dass die Richtung des Magnetfeldes im Wesentlichen mit einer Richtung der NV-Zentren ausgerichtet ist.

12. System nach einem der Ansprüche 2 bis 11, wobei der Magnetfeldgenerator ($G_B$) so konfiguriert ist, dass die Richtung des Magnetfelds in einer Ebene des Materials liegt.

13. System nach einem der Ansprüche 2 bis 12, wobei der Magnetfeldgenerator ($G_B$) so konfiguriert ist, dass die Richtung des Magnetfelds parallel zur Richtung X verläuft.

14. System nach einem der Ansprüche 2 bis 13, wobei der Magnetfeldgenerator so konfiguriert ist, dass die Magnetfeldamplitude entlang einer Richtung Z lotrecht zu einer Ebene des Materials im Wesentlichen konstant ist.

15. System nach einem der vorherigen Ansprüche, das ferner eine Sendeantenne (EA) umfasst, die in der Nähe des Materials (M) angeordnet und mit einem Koaxialkabel (C) verbunden ist, in dem das zu analysierende Mikrowellenfrequenzsignal (HF) zirkuliert.

**16.** System nach einem der vorherigen Ansprüche, das ein Verarbeitungsgerät umfasst, das zum Erfassen einer Vielzahl von Bildern zu aufeinanderfolgenden Zeitpunkten (t1, t2..., tn) und zum Erzeugen eines zweidimensionalen synthetischen Bildes (Is) durch Nebeneinanderstellen der erfassten Spektralbilder konfiguriert ist, um eine Entwicklung des Spektrums des zu analysierenden Mikrowellenfrequenzsignals (HF) in Abhängigkeit von der Zeit visuell darzustellen.

**17.** Verfahren zum Analysieren eines Mikrowellenfrequenzsignals (HF) durch Bildgebung, das die folgenden Schritte beinhaltet:

- optisches oder elektrisches Anregen einer Zone (Zo) eines festen Materials (M), von dem mindestens eine optische Eigenschaft in der Zone modifizierbar ist, wenn in der Zone gleichzeitig die Anregung und ein Mikrowellenfrequenzsignal mit mindestens einer Frequenz vorliegen, die mit einer Resonanzfrequenz ($f_R$) des Materials zusammenfällt,
wobei das Material ferner so ausgelegt ist, dass ein Wert der Resonanzfrequenz ($f_R$(B)) in Abhängigkeit von der Amplitude eines Magnetfeldes variiert,
- Erzeugen eines Magnetfeldes (B), das innerhalb eines Teils der Zone eine räumliche Amplitudenvariation (B(x)) aufweist, wobei das Material dann eine Resonanzfrequenz ($f_R$(x)) in Abhängigkeit von einer Position (x) entlang der Richtung X aufweist,
- Empfangen eines Bildes (Im) der Zone (Zo) in der Richtung X auf einem Detektor (D),
wobei das Bild mindestens eine Intensitätsvariation ($\delta$I) aufweist, von der eine Position in dem Bild von einem entsprechenden Frequenzwert des zu analysierenden Mikrowellenfrequenzsignals (HF) abhängig ist, das das Material beleuchtet, wenn der Teil der Zone des Materials gleichzeitig optisch oder elektrisch angeregt und dem Magnetfeld (B) ausgesetzt wird.

**18.** Verfahren nach Anspruch 17, das ferner die Schritte des Erfassens einer Vielzahl von Bildern zu aufeinanderfolgenden Zeitpunkten (t1, t2 ..., tn) und des Erzeugens eines zweidimensionalen synthetischen Bildes (Is) durch Nebeneinanderstellen der erfassten Bilder beinhaltet, um eine Entwicklung des Spektrums des zu analysierenden Mikrowellenfrequenzsignals (HF) in Abhängigkeit von der Zeit visuell darzustellen.

**19.** Verfahren nach Anspruch 17 oder 18, das ferner einen Kalibrierungsschritt beinhaltet, der darin besteht, ein synthetisches Bild auf der Basis eines Einfrequenz-Mikrowellenfrequenzsignals zu erzeugen, dessen Frequenz mit der Zeit nach einem bekannten Gesetz variiert, um eine Übereinstimmung zwischen der Position im Bild und der Resonanzfrequenz zu erhalten.

**Claims**

**1.** A system (10) for analyzing a microwave-frequency signal (HF) by imaging, comprising:

- a solid material (M) at least one optical property of which is modifiable in at least one zone (Zo) of said material, when said zone is simultaneously in the presence of an optical excitation (Eo) or electrical excitation (Ee) and a microwave-frequency signal having at least one frequency coinciding with a resonant frequency ($f_R$) of the material,
wherein said material is further adapted such that a value of said resonant frequency ($f_R$(B)) varies as a function of the amplitude of a magnetic field,
- a magnetic field generator ($G_B$) configured to generate a magnetic field (B) having, in the interior of a portion of said zone, a spatial amplitude variation (B(x)) in a direction X, said material then having a resonant frequency ($f_R$(x)) that is dependent on a position (x) in said direction X, and
- a detector (D) configured to receive an image (Im) of said zone (Zo) in said direction X,
said image having at least one intensity variation ($\delta$I) resulting from the modification of the optical property, a position of which in the spectral image depends on a corresponding frequency value of said microwave frequency signal (HF) to be analyzed illuminating said zone of the material, when said zone is simultaneously in the presence of an optical excitation (Eo) or electrical excitation (Ee) and said magnetic field (B).

**2.** The system according to claim 1, wherein the material is of planar geometry, the direction X being substantially contained in a plane of the material.

**3.** The system according to any one of claims 1 or 2, wherein the material is a crystal comprising color centers.

**4.** The system according to claim 3, wherein the crystal is a diamond substrate comprising NV centers in the crystal lattice of said substrate, each NV center consisting of a nitrogen atom substituted for a carbon atom and coupled to a vacancy, the nitrogen-atom/vacancy pair forming a color center in said crystal lattice.

**5.** The system according to any one of the preceding claims, wherein said optical property is an absorption of a probe optical beam (Fs) passing through said zone (Zo), said modification consisting of a variation in said absorption ($\delta A[Fs]$) of said probe optical beam (Fs) by said zone of the material.

**6.** The system according to any one of the preceding claims, wherein said optical property is a luminescence, said modification consisting of a variation in a light intensity ($\delta L$) of said zone, said system further comprising an optical system (S) configured to image said zone (Zo) on said detector (D).

**7.** The system according to any one of claims 3 to 6, wherein said NV centers of the diamond substrate have a preferred direction (DRp) among the four possible directions.

**8.** The system according to claim 7, wherein the preferred direction (DRp) of the NV centers is located in a plane of the material.

**9.** The system according to claim 8, wherein the preferred direction (DRp) of the NV centers corresponds to the direction X.

**10.** The system according to any one of the preceding claims, wherein the magnetic field generator ($G_B$) is configured so that the spatial variation in the amplitude of the magnetic field is monotonic along X in said portion of the zone (Zo).

**11.** The system according to any one of claims 3 to 10, wherein the magnetic field generator ($G_B$) is configured so that the direction of the magnetic field is substantially aligned with a direction of the NV centers.

**12.** The system according to any one of claims 2 to 11, wherein the magnetic field generator ($G_B$) is configured so that the direction of the magnetic field is contained in a plane of the material.

**13.** The system according to any one of claims 2 to 12, wherein the magnetic field generator ($G_B$) is configured so that the direction of the magnetic field is parallel to the direction X.

**14.** The system according to any one of claims 2 to 13, wherein the magnetic field generator is configured so that the amplitude of the magnetic field is substantially constant along a direction Z perpendicular to a plane of the material.

**15.** The system according to any one of the preceding claims, further comprising an emitting antenna (EA) placed in proximity to said material (M) and connected to a coaxial cable (C) inside of which the microwave-frequency signal (HF) to be analyzed propagates.

**16.** The system according to any one of the preceding claims, comprising a processing device configured to acquire a plurality of images at successive times (t1, t2..., tn) and to generate a two-dimensional synthetic image (Is) by juxtaposing the acquired spectral images, so as to visually render an evolution of the spectrum of the microwave-frequency signal (HF) to be analyzed as a function of time.

**17.** A method for analyzing a microwave-frequency signal (HF) by imaging, comprising the steps consisting in:

- optically or electrically exciting a zone (Zo) of a solid material (M) at least one optical property of which is modifiable in said zone when said zone is simultaneously in the presence of said excitation and a microwave-frequency signal having at least one frequency coinciding with a resonant frequency ($f_R$) of the material, wherein said material is further adapted such that a value of the resonant frequency ($f_R(B)$) varies as a function of the amplitude of a magnetic field,
- generating a magnetic field (B) having, in the interior of a portion of said zone, a spatial amplitude variation (B(x)), said material then having a resonant frequency ($f_R(x)$) that is dependent on a position (x) along said direction X,
- receiving on a detector (D) an image (Im) of said zone (Zo) in said direction X, said image containing at least one intensity variation ($\delta I$) a position of which in said image depends on a corresponding frequency value of said microwave frequency signal (HF) to be analyzed illuminating said material, when said portion of the zone of the material is simultaneously optically or electrically excited and subjected to said magnetic field (B).

**18.** The method according to claim 17, further comprising steps consisting in acquiring a plurality of images at successive times (t1, t2..., tn) and in generating a two-dimensional synthetic image (Is) by juxtaposing the acquired images, so as to visually render an evolution of the spectrum of the microwave-frequency signal (HF) to be analyzed as a function of time.

**19.** The method according to one of claims 17 or 18, further comprising a calibrating step consisting in generating a synthetic image from a mono-frequency microwave-frequency signal the frequency of which varies as a function of time according to a known law, so as to obtain a correspondence between position in the image and resonant frequency.

FIG.1

FIG.2

FIG.3

FIG.4

FIG.5

FIG.6

FIG.7

FIG.8

FIG.9

FIG.10

FIG.11a

FIG.11b

FIG.11c

FIG.12

FIG.13

FIG.14

FIG.15

1mm

M

FIG.16

EA

M

DL

D

FIG.17

FIG.18

FIG.19

**EP 3 213 093 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2013188732 A